# EUROPEAN PATENT APPLICATION

(11) **EP 2 753 156 A1**
(43) Date of publication of application: **09.07.2014**
(21) Application number: 13158894.9
(22) Date of filing: 13.03.2013
(51) Int. Cl.: H05K 1/14, F21K 99/00, F21S 4/00, H05K 3/36

(54) **Light emitting module**

(30) Priority: 26.12.2012 JP 2012283612
(71) Applicant: Toshiba Lighting & Technology Corporation, Yokosuka-shi Kanagawa 237-8510 (JP)
(72) Inventor: Shibusawa, Soichi, Kanagawa, 237-8510 (JP); Hayashida, Yumiko, Kanagawa, 237-8510 (JP)
(74) Representative: Bokinge, Ole

(57) **Abstract**

A light emitting module (20) is a light emitting module including a substrate (21), a first area (22) in which LED chips (40) are mainly arranged and mounted in a longitudinal direction of the substrate in an area on one side of the longitudinal direction, a second area (23) in which non-light emitting components (30) are mainly mounted in an area on another side of the longitudinal direction of the substrate and a notch portion (24) which is between the first area (22) and the second area (23) and formed on the substrate. The non-light emitting components (30) are mountable across the notch portion (24) between the first area (22) and the second area (23). Further, the substrate (21) is separable into the first area (22) and the second area (23) by the notch portion (24). Furthermore, the first area (22) after separation is formed to be connectable consecutively with another light emitting module (20B) in the longitudinal direction.

## Description

### FIELD

Embodiments described herein relate generally to a light emitting module.

### BACKGROUND

Recently, as an example of a mounting method of a light emitting module, COB (Chip On Board) method which mounts light emitting components such as a plurality of LED (Light Emitting Diode) chips on a board is known.

The light emitting module adapting the COB method is used, for example, as a light source of a bulb-shaped LED lamp having a plurality of LED chips mounted. Further, in recent years, a light emitting module appears in which LED chips are arranged and mounted at the same interval in a row on a substrate. Further, a straight-tube type LED lamp configured by connecting a plurality of the light emitting modules is also known.

Further, the light emitting module of the straight-tube type LED lamp has a type in which only the LED chips are mounted on the substrate and a type in which non-light emitting components such as, for example, a connector and a fuse, as well as the LED chips are mounted on the substrate. In the light emitting module of the type in which the LED chip and the non-light emitting component are mounted on the substrate, a slit is formed between an area on which the LED chip is mounted and an area on which the non-light emitting component is mounted, in the substrate. Then, by cutting the slit part in the substrate, the area on which the non-light emitting component is mounted is separated from the substrate and then the separated area can be used as the light emitting module of the type in which the LED chip is mounted.

In the light emitting module of the type in which the LED chip and the non-light emitting component are mounted on the substrate, a slit is formed between an area on which the LED chip is mounted and an area on which the non-light emitting component is mounted. However, since the slit is formed in the area on which the LED chip is mounted, the length of the straight-tube type LED lamp is specified in the product specification, but the area on which the LED chip is mounted becomes narrower by the space occupied by the slit.

Embodiments provide a light emitting module and the like capable of enlarging the mounting area of the light emitting component on the substrate.

### DESCRIPTION OF THE DRAWINGS

FIG. 1 is a perspective view illustrating an example of a lighting fixture relating to a first embodiment.
FIG. 2 is a schematic cross-sectional view of the lighting fixture.
FIG. 3 is an explanatory view illustrating an example of a wire connection in the lighting fixture.
FIG. 4 is a plan view illustrating an example of a mounting type light emitting module.
FIG. 5 is a plan view illustrating an example of a case where a second area is separated from the mounting type light emitting module.
FIG. 6 is a schematic cross-sectional view taken along A-A line of FIG. 4.
FIG. 7 is a plan view illustrating an example of a non-mounting type light emitting module.
FIG. 8 is a plan view illustrating an example of an LED lamp module relating to the first embodiment.
FIG. 9 is a plan view illustrating an example of an LED lamp module relating to a second embodiment.

### DETAILED DESCRIPTION

Hereinafter, a light emitting module and the like according to various embodiments will be described referring to the accompanying drawings. In each embodiment, the same configurations are denoted by the same reference numerals, so that the descriptions of the repeated configurations and operations thereof will be omitted. Moreover, a light emitting module and a light source device that will be described in the embodiments below illustrate only an example, but are not limited to the exemplary embodiment. The following embodiments may be appropriately combined within a range that is not contradictory.

In the present embodiment, a light source device configured by connecting consecutively a plurality of light emitting modules including a substrate on which light emitting components are mounted in the longitudinal direction of the substrate will be described. Here, an example of an advantage to be obtained when the light source device is configured not by a single light emitting module but by combining a plurality of light emitting modules will be described. For example, the light source device is configured by combining the plurality of light emitting modules, so that the length of each substrate becomes short. This suppresses the occurrence of the warpage of the substrates, and hence, the occurrence of the disconnection of the wires provided in the substrates. As a result, the light source device is configured by combining a plurality of the light emitting modules, so that suppression of the manufacturing cost can be expected.

In the embodiment, the light emitting module includes a substrate, a first area, a second area and a notch portion. The first area is an area on which light emitting components are mainly arranged and mounted in the area of one side in the longitudinal direction of the substrate. The second area is an area on which non-light emitting components are mainly mounted in the area of the another side in the longitudinal direction of the substrate. The notch portion is between the first area and the second area, and formed on the substrate. In the substrate, the non-light emitting component may be mounted across the notch portion between the first area and the second area. The substrate can be separated into the first area and the second area by the notch portion, and the first area after the separation is formed to be connected consecutively with another light emitting module in the longitudinal direction. As a result, the notch portion is formed such that the non-light emitting component can be mounted across the notch portion between the first area and the second area, thereby enlarging the mounting area of the light emitting component that can be mounted in the first area. In addition, the substrate can be separated into the first area and the second area, and the notch portion is formed such that the divided first area can be connected with another light emitting module in the longitudinal direction, and thus only the first area on which the light emitting component is mounted can be used as the light emitting module.

Further, in the embodiment, the mounting interval between the light emitting components that are adjacent with each other at the same interval in the first area have the same dimension as the mounting interval between the light emitting components that are arranged and mounted in the longitudinal direction in the substrate within another light emitting module that is connected to the first area and are adjacent with each other at the same interval. As a result, the mounting interval between the light emitting components on the first area from which the second area is separated has the same dimension as the mounting interval between the light emitting components in another light emitting module, thereby suppressing uneven light emission caused by the different mounting intervals between the light emitting component of each light emitting module when a plurality of light emitting modules are linked.

Further, in the embodiment, the substrate length of the longitudinal direction of the substrate of the first area is the same as the substrate length of the longitudinal direction of the substrate on which the light emitting components are arranged in the longitudinal direction of the substrate in the other light emitting module connected to the first area. As a result, the substrate length of the first area from which the second area is separated is the same as the substrate length of the substrate of the other light emitting module, thereby enabling a common substrate to be used in the different light emitting modules.

In the embodiment, the edge portion of the side that is opposed to the notch portion in the first area in another light emitting module can be connected with the edge portion of the notch portion side in the first area from which the second area is separated by the notch portion. The flat surface that is the edge portion of the side, that is opposed to the notch portion in the first area of the other light emitting module is connected with the concave-convex surface that is the edge portion of the notch portion side in the first area from which the second area is separated. Therefore, this enables the link between the light emitting modules to be smoothly performed.

In the embodiment, when the non-light emitting component is mounted across and above the notch portion, the notch portion is formed such that a creeping distance is ensured in the distance from the edge portion on the notch portion side to the mounting part of the non-light emitting component to be mounted. As a result, it is possible to form the notch portion while ensuring the creeping distance.

In the embodiment, the mounting interval between the light emitting components that are adjacent with each other at the same interval in the first area is made to be at least the creeping distance or more. As a result, the creeping distance can be ensured in the mounting interval between the light emitting components that are adjacent with each other in the first area.

In the embodiment, the light source device includes a first light emitting module and a second light emitting module. The first light emitting module has a first substrate, and has a first area, a second area, and a notch portion. The first area is an area where, the light emitting component is mainly arranged and mounted in the longitudinal direction in an area of one side of the longitudinal direction of the first substrate. The second area is an area where, the non-light emitting component is mainly mounted in an area of the another side of the longitudinal direction of the first substrate. The notch portion is between the first area and the second area, and formed on the substrate. On the first light emitting module, the non-light emitting component is mounted across the notch portion between the first area and the second area. The second light emitting module includes a second substrate. After the first substrate is separated into the first area and the second area by the notch portion, the second substrate is configured by the corresponding first area. In the second substrate, the light emitting components are arranged and mounted in the longitudinal direction of the corresponding second substrate. The first area of the first light emitting module and the first area of the second light emitting module are provided to be connected consecutively in the longitudinal direction. As a result, the notch portion across which the non-light emitting components are mounted between the first area and the second area is formed, thereby enlarging the mounting area of the light emitting components that can be mounted in the first area. Further, since the first substrate can be separated into the first area and the second area, and the notch portion is formed such that the corresponding first area after the separation can be connected with other light emitting modules in the longitudinal direction, only the first area on which the light emitting component is mounted can be used as the light emitting module.

In the embodiment, the mounting interval between the light emitting components that are adjacent with each other at the same interval in the first area in the first light emitting module have the same dimension as the mounting interval between the light emitting components that are adjacent with each other at the same interval in the first area in the second light emitting module. As a result, it is possible to suppress uneven light emission caused by the different mounting interval between the light emitting components of the first light emitting module and the second light emitting module when the first light emitting module and the second light emitting module are linked.

In the embodiment, the substrate length of the longitudinal direction of the first substrate of the first area in the first light emitting module is the same as the substrate length of the longitudinal direction of the second substrate of the first area in the second light emitting module connected to the first area. As a result, the substrate length of the first area in the first light emitting module is the same as the substrate length of the first area in the second light emitting module, thereby enabling a common substrate to be used in the first light emitting module and the second light emitting module.

In the embodiment, the first area of the first light emitting module and the second area of the second light emitting module are provided to be connected consecutively such that the remaining area of the notch portion caused by the separation of the second light emitting module and the first area of the first light emitting module are adjacent with each other. As a result, since the flat surface of the first area in the first light emitting module is connected with the concave-convex surface as the remaining area of the notch portion of the second light emitting module, the link between the first light emitting module and the second light emitting module is smoothly made.

In the embodiment, after the first substrate is separated into the first area and the second area by the notch portion, a third substrate configured by the corresponding first area is provided, and a third light emitting module on which the light emitting components are arranged and mounted in the longitudinal direction of the corresponding third substrate is provided in the third substrate. In addition, the first area of the second light emitting module and the first area of the third light emitting module are provided to be connected consecutively such that the remaining area of the notch portion caused by the separation of the third light emitting module and the first area of the second light emitting module are adjacent with each other. As a result, since the flat surface of the first area in the second light emitting module is connected with the concave-convex surface as the remaining area of the notch portion of the third light emitting module, the link between the second light emitting module and the third light emitting module is smoothlymade. That is, it is possible to sequentially link the light emitting modules of three or more.

In the embodiment, when the non-light emitting component is mounted across and above the notch portion of the first substrate, the notch portion is formed such that the creeping distance is ensured in the distance from the edge portion of the notch portion to the mounting part of the non-light emitting component to be mounted. As a result, it is possible to form the notch portion in which the creeping distance is ensured.

In the embodiment, the mounting interval between the light emitting components that are adjacent with each other at the same interval in the first area is made to be the creeping distance or more. As a result, in the mounting interval between the light emitting components that are adjacent with each other in the first area, the creeping distance can be ensured.

In the embodiment, as the light emitting component, an LED chip is used, but without being limited thereto, for example, a semiconductor laser or an EL (Electro Luminescence) device can also be used. In a case of using the LED chip as the light emitting element, the light emitting color of the LED chip may be any one of red, green and blue. Further, the LED chips having different colors can be combined to be used. Furthermore, the non-light emitting component may be, for example, an electric circuit such as a rectifying circuit, a connector or a resistor.

### (First embodiment)

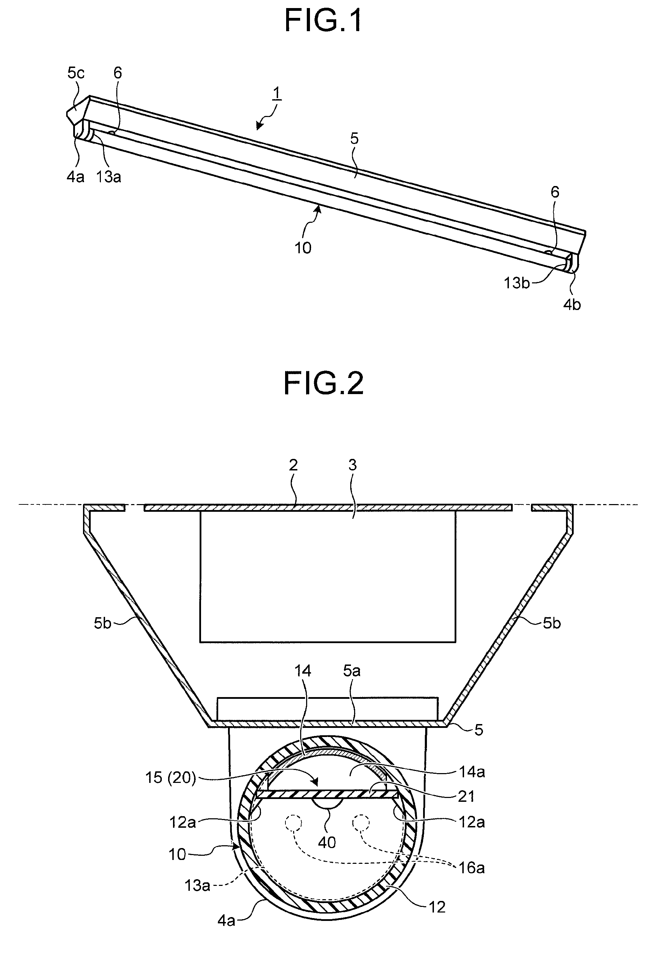

Hereinafter, based on the drawings, a lighting fixture which is a lighting device including a straight-tube type LED lamp relating to a first embodiment will be described. FIG. 1 is a perspective view illustrating an example of the lighting fixture relating to the first embodiment. FIG. 2 is a cross-sectional view of the lighting fixture shown in FIG. 1.

The lighting fixture 1 includes a fixture main body 2, a light switching unit 3, a pair of first and second sockets 4a, 4b, a metallic reflection member 5, a straight-tube type LED lamp 10 that is a light source device and the like. The fixture main body 2 shown in FIG. 2 is configured by, for example, a metal plate having a long and thin shape, and extended in both directions of the sheet surface on which FIG. 2 is drawn. The fixture main body 2 is fixed to, for example, the ceiling in a room using a plurality of screws not shown.

The light switching unit 3 is fixed to the intermediate portion of the longitudinal direction of the fixture main body 2. The light switching unit 3 converts an alternating current (AC) power from the AC power source into a direct current (DC) power and supplies the converted DC power to the LED lamp 10. Moreover, a power supply terminal board (not shown), a plurality of member supporting metal fittings, a pair of socket supporting members, and the like are respectively attached to the fixture main body 2. Power lines from the AC power source drawn from the inside of the ceiling are connected to the power supply terminal board. In addition, the power supply terminal board is electrically connected to the light switching unit 3 through the wires within the fixtures, not shown.

The first and second sockets 4a, 4b are linked to the socket supporting member, not shown, and respectively provided in both edges of the longitudinal direction of the fixture main body 2. The first and second sockets 4a, 4b are to be rotationally installed. The first and second sockets 4a, 4b are sockets suitable for, for example, G13 type of first and second mouthpieces 13a, 13b that the LED lamp 10 includes.

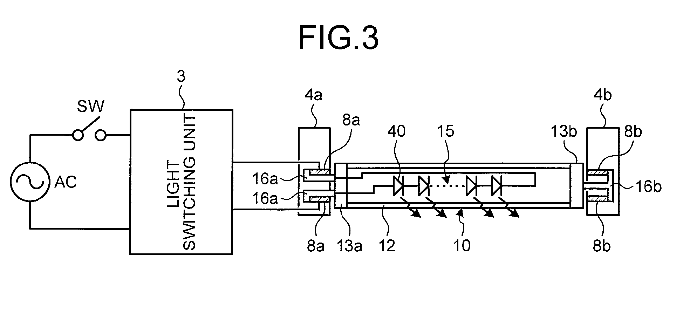

FIG. 3 is an explanatory view illustrating an example of a wire connection in the lighting fixture 1 of FIG. 1. The first and second sockets 4a, 4b shown in FIG. 3 includes a pair of terminal metal fittings 8a or 8b to which lamp pins 16a, 16b described later are connected. The terminal metal fitting 8a of the first socket 4a is connected to the light switching unit 3 through the wires within the fixture to supply electricity to the LED lamp 10. In addition, no wires are connected to the terminal metal fitting 8b of the second socket 4b.

The reflection member 5 shown in FIG. 2 has, for example, a lower plate portion 5a, side plate portions 5b, and edge plates 5c, and has a trough shape of which the upper surface is opened. The lower plate portion 5a is a flat plate having a flat surface. The side plate portions 5b are formed by bending obliquely and upwardly both edges of the lower plate portion 5a from both edges of the width direction of the lower plate portion 5a. The edge plates 5c are to block the edge surface openings configured by the edges of the longitudinal direction of the lower plate portion 5a and the side plate portions 5b. Moreover, the metal plate forming the lower plate portion 5a and the side plate portions 5b is made from a color steel plate of which surface exhibits a white-based color. The surfaces of the lower plate portion 5a and the side plate portions 5b are reflection surfaces. The socket through holes, not shown, are respectively formed in both edges of the longitudinal direction of the lower plate portion 5a.

The reflection member 5 covers the fixture main body 2 and each of the components attached to the fixture main body 2. Further, in the state where the fixture main body 2 and each component are covered by the reflection member 5, and the fixture main body 2 and each component are held by the detachable screw 6. The screw 6 is penetrated upwardly through the lower plate portion 5a of the reflection member 5 and is screwed to the member supporting metal fittings. When the screw 6 is, for example, a decorative screw, the screw 6 can be screwed by hand without using tools. The first and second sockets 4a, 4b protrude downward from the lower plate portion 5a through the socket through hole.

The lighting fixture 1 is not limited to a configuration which supports one LED lamp 10, but can include, for example, two sets of first and second sockets 4a, 4b to support two LED lamps 10. Next, description of the LED lamp 10 that is detachably connected to the first and second sockets 4a, 4b will be made.

The LED lamp 10 has the same dimension and outer diameter as the straight-tube type fluorescent lamp. The LED lamp 10 includes a pipe 12, a first mouthpiece 13a and a second mouthpiece 13b that are attached in both edges of the pipe 12, a beam 14, and an LED lamp module 15.

The pipe 12 is formed into, for example, an elongated shape using a light transmitting resin material. As the resin material used in the pipe 12, for example, polycarbonate resin is preferable in which a light diffusion material is mixed. Further, it is preferable that the diffuse transmittance of the pipe 12 is, for example, within the range of 90% to 95%. Further, the pipe 12 that is shown in FIG. 2 has a pair of convex portions 12a formed in the inner surface of the part that is the upper part in use.

The first mouthpiece 13a is attached in one edge portion of the longitudinal direction of the pipe 12 and the second mouthpiece 13b is attached in the other edge portion of the longitudinal direction of the pipe 12. Those first and second mouthpieces 13a, 13b are detachably connected to the first and second sockets 4a, 4b. As a result, the LED lamp 10 that is supported in the first and second sockets 4a, 4b is disposed immediately below the lower plate portion 5a of the reflection member 5. A part of the light emitted from the LED lamp 10 to the outside is incident on the side plate portions 5b of the reflection member 5.

The first mouthpiece 13a shown in FIG. 3 has the two lamp pins 16a protruding outside thereof. The two lamp pins 16a are electrically isolated from each other. In addition, the leading edges of the two lamp pins 16a are bent substantially at a right angle in order to be separated with each other and form into an L-shape. In addition, the second mouthpiece 13b has one lamp pin 16b protruding outside. The one lamp pin 16b has a cylindrical axial portion and a leading edge portion that is provided in the leading edge portion of the cylindrical axial portion and of which the front shape (not shown) is an ellipse shape or an oval shape, and the side surface forms into a T-shape.

The lamp pins 16a of the first mouthpiece 13a are connected to the terminal metal fitting 8a in the first socket 4a and the lamp pin 16b of the second mouthpiece 13b is connected to the terminal metal fitting 8b in the second socket 4b. As a result, the LED lamp 10 is mechanically supported by the first and second sockets 4a, 4b. Then, the terminal metal fitting 8a within the first socket 4a and the lamp pins 16a of first mouthpiece 13a are connected, thereby supplying the electricity to the LED lamp 10.

The beam 14 shown in Fig 2 is accommodated in the pipe 12. The beam 14 is a bar material that is excellent in mechanical strength, and made from, for example, aluminum alloy for reducing in weight. Both edge portions of the longitudinal direction of the beam 14 is electrically insulated and linked with the first mouthpiece 13a and the second mouthpiece 13b. The beam 14 includes, for example, a plurality of substrate supporting portions 14a that form a rib shape (one substrate supporting portion is shown in FIG. 2).

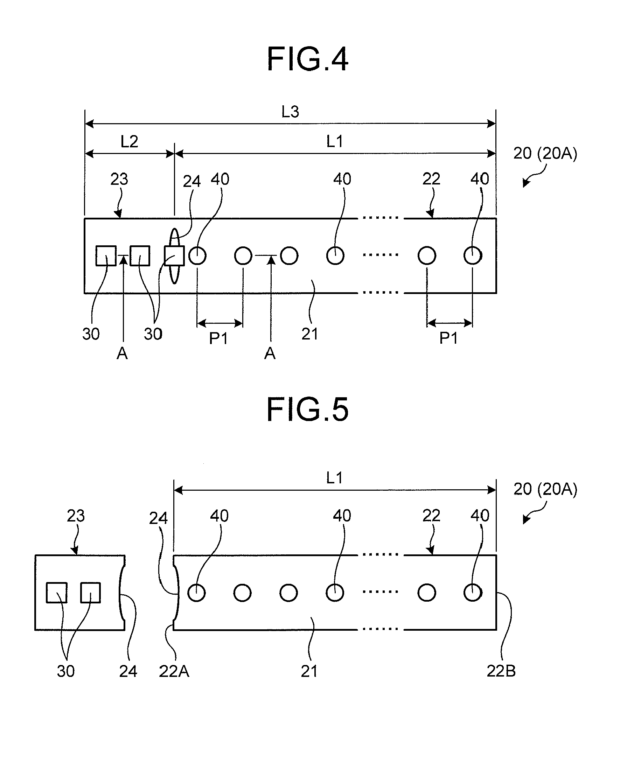

The LED lamp module 15 is configured by linking and connecting a plurality of, for example, four light emitting modules 20. The light emitting module 20 includes a mounting type light emitting module on which non-light emitting components 30 are mounted and a non-mounting type light emitting module on which the non-light emitting components 30 are not mounted. FIG. 4 is a plan view illustrating an example of a mounting type light emitting module 20A. The mounting type light emitting module 20A shown in FIG. 4 is a light emitting module of the type on which the non-light emitting components 30 are mounted. In addition, the non-light emitting component 30 is, for example, an electronic component other than the light emitting component such as an LED chip 40. The electronic component includes, for example, a rectifying circuit such as a diode, an electrical resistor such as a fuse, a connector, and the like. The rectifying circuit is a circuit that rectifies the power supplied from the light switching unit 3.

The light emitting module 20A includes a first substrate 21. The first substrate 21 is configured by, for example, a base material such as a substrate of a glass epoxy resin (FR-4) and a glass composite substrate (CEM-3). The first substrate 21 includes a first area 22, a second area 23, and a notch portion 24. The first area 22 is an area in which the LED chips 40 are mainly arranged and mounted at the same interval in the longitudinal direction in an area on one side of the longitudinal direction of the first substrate 21. In addition, the LED chip 40 is configured by, for example, a bare chip of an LED that emits a blue color light, includes light emitting layer on one surface of the element substrate made from sapphire, and the plan shape thereof is rectangular.

The second area 23 is an area on which the non-light emitting components 30 are mainly mounted in an area of another side of the longitudinal direction of the first substrate 21.

The notch portion 24 is a long-hole shaped slit formed on the boundary such that the non-light emitting components 30 can be mounted across the boundaries of the first area 22 and the second area 23. In addition, by the notch portion 24 on the boundary, the first substrate 21 can be divided into the first area 22 and the second area 23. Further, in the notch portion 24, the first area 22 after the separation can be connected with another light emitting module 20 in the longitudinal direction. FIG. 5 is a plan view illustrating an example of a case where the second area 23 is separated from the mounting type light emitting module 20A. The manufacturer can separate the second area 23 from the first area 22 as shown in FIG. 5 by cutting the part in the notch portion 24 and can use only the first area 22 as the light emitting module. Then, a concave-convex surface 22A of the first area 22 from which the second area 23 is separated and a flat surface 22B of the first area 22 in another light emitting module 20 are connected in the longitudinal direction of the first substrate 21. In addition, the concave-convex surface 22A is the remaining part of the notch portion 24.

Further, the dimension of the mounting interval between the LED chips 40 that are adjacent with each other at the same interval in the first area 22 is P1, the substrate length of the longitudinal direction of the first substrate 21 of the first area 22 is L1, the substrate length of the longitudinal direction of the first substrate 21 of the second area 23 is L2, and the substrate length of the longitudinal direction of the first substrate 21 is L3.

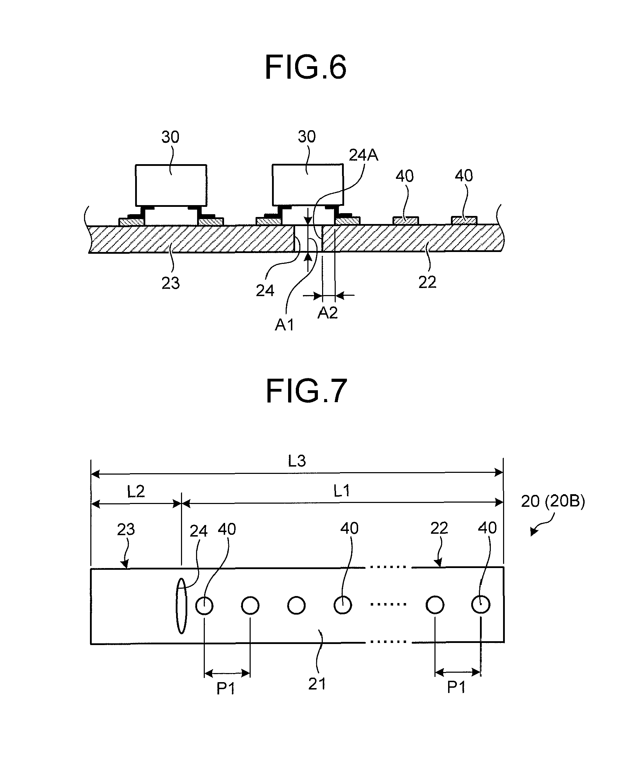

FIG. 6 is a schematic cross-sectional view taken along A-A line of FIG. 4. When the non-light emitting component 30 is mounted across above the notch portion 24 on the boundary, the mounting type light emitting module 20A shown in FIG. 6 ensures the distance (A1+A2) from an edge portion 24A of the notch portion 24 to a pad portion 30A that is a mounting part of the non-light emitting component 30 to be mounted as the creeping distance, and the notch portion 24 is formed in the boundary between the first area 22 and the second area 23.

In contrast, a non-mounting type light emitting module 20B is a light emitting module in which the non-light emitting components 30 are not mounted on the second area 23. FIG. 7 is a plan view illustrating an example of the non-mounting type light emitting module 20B. The non-mounting type light emitting module 20B shown in FIG. 7 is different from the mounting type light emitting module 20A shown in FIG. 4 in that the non-light emitting component 30 is not mounted on the notch portion 24 formed in the boundary between the first area 22 and the second area 23.

The manufacturer can separate the second area 23 from the first area 22 by cutting the part in the notch portion 24 of the non-mounting type light emitting module 20B and can use only the first area 22 as the light emitting module.

In addition, also in the non-mounting type light emitting module 20B, without mounting the non-light emitting component 30 across and above the notch portion 24, the notch portion 24 can be formed in the boundary between the first area 22 and the second area 23 while ensuring the creeping distance (A1+A2) similar to the mounting type light emitting module 20A. That is, the mounting interval between the LED chips 40 that are adjacent with each other within the first area 22 of the light emitting module 20 has the dimension P1 of the creeping distance or more.

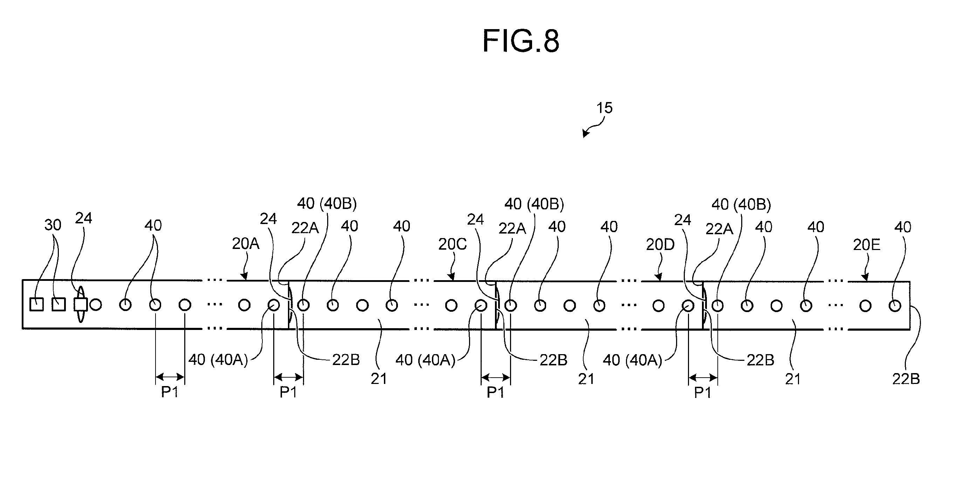

Next, the description of a method of assembling the LED lamp module 15 using the light emitting modules 20 will be made. FIG. 8 is a plan view illustrating an example of the LED lamp module 15 relating to the first embodiment. The manufacturer prepares one mounting type light emitting module 20A and three non-mounting type light emitting modules 20B that are used in the LED lamp module 15.

The manufacturer separates the second area 23 from the first area 22 by cutting the part in the notch portion 24 of the first substrate 21 of the non-mounting type light emitting module 20B to manufacture light emitting modules 20C, 20D, 20E configured by only the first area 22. Then, the manufacturer links and connects the mounting type light emitting module 20A and the light emitting module 20C in the longitudinal direction of the first substrate 21. That is, the flat surface 22B that is an edge portion of the first area 22 on the side opposed to the notch portion 24 within the mounting type light emitting module 20A and the concave-convex surface 22A on the notch portion 24 side that is an edge portion of the first area 22 within the light emitting module 20C are linked and connected. In this case, the distance between an LED chip 40A on the flat surface 22B side of the first area 22 of the mounting type light emitting module 20A and an LED chip 40B on the concave-convex surface 22A side of the first area 22 within the light emitting module 20C has the same dimension P1 as the dimension of the mounting interval.

Further, the manufacturer connects the flat surface 22B on the light emitting module 20C side with the concave-convex surface 22A on the light emitting module 20D side so that the light emitting module 20C and the light emitting module 20D are linked and connected. In this case, the distance between the LED chip 40A on the flat surface 22B side of the first area 22 of the light emitting module 20C and the LED chip 40B on the concave-convex surface 22A side of the first area 22 within the light emitting module 20D is the same dimension P1 as the dimension of the mounting interval.

Further, the manufacturer connects the flat surface 22B on the light emitting module 20D side with the concave-convex surface 22A on the light emitting module 20E side so that the light emitting module 20D and the light emitting module 20E are linked and connected. In this case, the distance between the LED chip 40A on the flat surface 22B side of the first area 22 of the light emitting module 20D and the LED chip 40B on the concave-convex surface 22A side of the first area 22 within the light emitting module 20E has the same dimension P1 as the dimension of the mounting interval.

As a result, the LED lamp module 15 is assembled by linking and connecting the mounting type light emitting module 20A with the light emitting modules 20C, 20D and 20E. In this case, the LED lamp module 15 is in the state where a plurality of LED chips 40 are arranged and mounted in the longitudinal direction at the mounting interval of the same dimension P1. In addition, the entire length of the LED lamp module 15 is approximately the same as the entire length of the beam 14. Each light emitting module 20 within the LED lamp module 15 is fixed with screws, not shown, that are screwed to the beam 14.

The LED lamp module 15 and the beam 14 are accommodated in the pipe 12. In the state being fixed to the beam 14 with the screw, not shown, both edge portions of each of the light emitting modules 20A, 20C, 20D, 20E in the width direction within the LED lamp module 15 are placed on the convex portion 12a of the pipe 12. As a result, the LED lamp module 15, as shown in FIG. 2, is provided substantially horizontally in the upper side than the maximum width within the pipe 12. As a result, the straight-tube type LED lamp 10 in which the LED lamp modules 15 are embedded can be manufactured.

Then, in the state where both edges of the LED lamp 10 are installed in the first and second sockets 4a, 4b within the lighting fixture 1, the light switching unit 3 of the lighting fixture 1 supplies the electricity to the LED lamp 10 if the turn-on operation of the switch is detected. Each LED chip 40 of each light emitting module 20 within the LED lamp module 15 in the LED lamp 10 emits light all at once in response to the electricity supply from the switching unit 3, accordingly, the white light emitted from the sealing member of the LED chip 40 is diffused in the pipe 12 and transmitted through the pipe 12 to be emitted to the outside. As a result, the LED lamp 10 illuminates the lower space of the LED lamp 10, and also a part of the white light emitted from the pipe 12 is reflected on the side plate portions 5b of the reflection member 5 and illuminates the upper space of the LED lamp 10.

In the light emitting module 20 of the first embodiment, the notch portion 24, on which the non-light emitting component 30 can be mounted across the boundary between the first area 22 and the second area 23, is formed on the boundary, thereby enlarging the mounting area of the LED chip 40 that can be mounted in the first area 22. In addition, the first substrate 21 can be separated into the first area 22 and the second area 23, and the notch portion 24 is formed such that the corresponding first area 22 after the separation can be connected with other light emitting modules 20 in the longitudinal direction, thereby using only the first area 22 on which the LED chip 40 is mounted, as the light emitting module 20.

In the light emitting module 20 of the first embodiment, the mounting interval between the LED chips 40 on the first area 22 from which the second area 23 is separated and the mounting interval between the LED chips 40 in the another light emitting module 20 have the same dimension P1, thereby suppressing uneven light emission caused by the different mounting interval between the LED chips 40 in each light emitting module 20, when a plurality of light emitting modules 20 are linked.

In the light emitting module 20 of the first embodiment, the substrate length of the first area 22 from which the second area 23 is separated and the substrate length of the first area 22 in another light emitting module 20 have the same dimension L1, thereby enabling a common substrate to be used in the different light emitting modules 20.

In the light emitting module 20 of the first embodiment, the concave-convex surface 22A on the notch portion 24 side of the first area 22 from which the second area 23 is separated is connected with the flat surface 22B of the first area 22 in another light emitting module 20, so that the link between the light emitting modules 20 is performed smoothly.

In the light emitting module 20 of the first embodiment, even when the non-light emitting component 30 is mounted across the boundary above the notch portion 24, it is possible to form the notch portion 24 in which the creeping distance (A1+A2) is ensured in the boundary between the first area 22 and the second area 23.

In the light emitting module 20 of the first embodiment, since the dimension P1 of the mounting interval between the LED chips 40 that are adjacent with each other in the first area 22 is the creeping distance or more, the creeping distance can be ensured in the mounting interval.

Further, in the above first embodiment, the LED lamp module 15 which is embedded in the LED lamp 40 is manufactured using the mounting type light emitting module 20A and the non-mounting type light emitting module 20B. However, for example, the LED lamp module may be manufactured using the existing non-mounting type light emitting module other than the non-mounting type light emitting module 20B. Hereinafter, the description of the embodiment in this case will be made.

### (Second Embodiment)

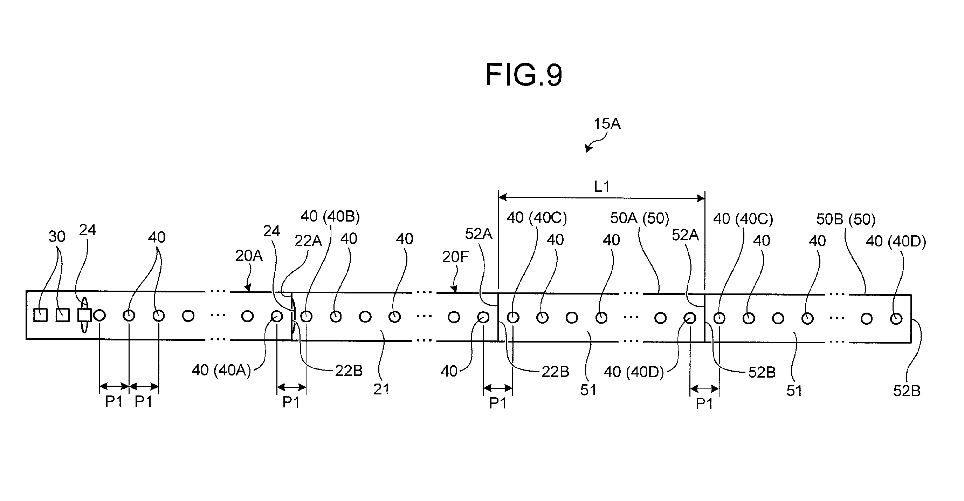

FIG. 9 is a plan view illustrating an example of an LED lamp module relating to the second embodiment. An LED lamp module 15A shown in FIG. 9 is configured by one mounting type light emitting module 20A, one non-mounting type light emitting module 20B, and two existing non-mounting type light emitting modules 50.

The existing non-mounting type light emitting module 50 includes a second substrate 51, and the LED chips 40 are arranged and mounted in the longitudinal direction of the second substrate 51 at the mounting interval of the same dimension P1. The substrate length of the longitudinal direction of the light emitting module 50 has the same dimension L1 as the substrate length of the first area 22 of the mounting type light emitting module 20A.

The manufacturer prepares one mounting type light emitting module 20A, one non-mounting type light emitting module 20B, and two existing non-mounting type light emitting modules 50.

The manufacturer separates the second area 23 from the first area 22 by cutting the part in the notch portion 24 of the first substrate 21 of the non-mounting type light emitting module 20B to manufacture a light emitting module 20F configured only by the first area 22. Then, the manufacturer links and connects the mounting type light emitting module 20A and the light emitting module 20F. That is, the flat surface 22B that is the edge portion of the first area 22 in the mounting type light emitting module 20A and the concave-convex surface 22A that is the edge portion of the first area 22 in the light emitting module 20F are linked and connected. In this case, the distance between the LED chip 40A on the flat surface 22B side of the first area 22 in the light emitting module 20A and the LED chip 40B on the concave-convex surface 22A side of the first area 22 in the light emitting module 20F is the same dimension P1 as the dimension of the mounting interval.

The manufacturer links and connects the light emitting module 20F with the existing non-mounting type light emitting module 50A by connecting the flat surface 22B on the light emitting module 20F side with a first flat surface 52A on the existing light emitting module 50A side. In this case, the distance between the LED chip 40A on the flat surface 22B side of the first area 22 of the light emitting module 20F and LED chips 40C on the first flat surface 52A side in the existing light emitting module 50A has the same dimension P1 as the dimension of the mounting interval.

The manufacturer links and connects the existing light emitting module 50A with an existing light emitting module 50B by connecting a second flat surface 52B on the existing light emitting module 50A side with the first flat surface 52A on the existing light emitting module 50B side. In this case, the distance between LED chips 40D on the second flat surface 52B side of the existing light emitting module 50A and LED chips 40C on the first flat surface 52A side in the existing light emitting module 50B has the same dimension P1 as the dimension of the mounting interval.

As a result, the LED lamp module 15A is assembled by linking and connecting the mounting type light emitting module 20A, the light emitting module 20C, and the existing non-mounting type light emitting modules 50A and 50B. In this case, the LED lamp module 15A is in the state where a plurality of LED chips 40 are arranged and mounted in the longitudinal direction at the mounting interval of the same dimension P1.

In the second embodiment, the LED lamp module 15A can be assembled using the existing light emitting module 50 as well as the mounting type light emitting module 20 and the non-mounting type light emitting module 20 in which the mounting area of the LED chip 40 is enlarged.

While respective embodiments have been described, these embodiments have been presented by way of example only, and are not intended to limit the scope of the exemplary embodiments. Indeed, the novel embodiments described herein may be embodied in a variety of other forms; furthermore, various omissions, substitutions and changes in the form of the embodiments described herein may be made without departing from the spirit of the exemplary embodiments. The accompanying claims and their equivalents are intended to cover such forms or modifications as would fall within the scope and spirit of the exemplary embodiments.

## Claims

1. A light emitting module (20) comprising:
a substrate(21);
a first area (22) in which light emitting components (40) are arranged and mounted along a longitudinal direction of the substrate;
a second area (23) in which non-light emitting components (30) are mounted; and
a notch portion (24) formed on the substrate between the first area (22) and the second area (23),
wherein the substrate (21) is configured to have a non-light emitting component mounted across the notch portion (24) between the first area and the second area, and to be separable into the first area (22) and the second area (23) by the notch portion (24), the first area (22) after separation being connectable consecutively with another light emitting module (20) in the longitudinal direction.

2. The module (20) according to claim 1,
wherein the notch portion (24) is formed so that a distance from an edge portion (24A) of the notch portion (24) to a mounting pad (30A) for the non-light emitting component (30) on the substrate is greater than or equal to a creeping distance (A1 + A2) for the light emitting components, when the non-light emitting component (30) is mounted across and above the notch portion (24).

3. The module (20) according to claim 2,
wherein a mounting interval (P1) between the light emitting components (40) is greater than or equal to the creeping distance.

4. The module (20) according to any one of claims 1 to 3,
wherein a mounting interval between the light emitting components (40) is equal to a mounting interval between light emitting components (40) that are arranged and mounted in a longitudinal direction of a substrate of another light emitting module (20) to be connected to the first area (22) in the longitudinal direction.

5. The module (20) according to any one of claims 1 to 4,
wherein a length in the longitudinal direction of the first area is the same as a length in the longitudinal direction of a substrate of another light emitting module (20) to be connected with the first area.

6. The module (20) according to any one of claims 1 to 5,
wherein the first area is to be connected with another light emitting module on a side of the first area that is opposite to a side of the notch portion.

7. The module according to claim 6,
wherein the first area is connected to a notch portion side of the another light emitting module.

8. The module (20) according to any one of claims 1 to 7,
wherein the another light emitting module is a first light emitting module including:
a first substrate(21);
a first area (22) in which light emitting components (40) are mainly arranged and mounted in a longitudinal direction of the first substrate in an area on one side of the longitudinal direction;
a second area (23) in which non-light emitting components (30) are mainly mounted in an area on another side of the longitudinal direction of the first substrate; and
a notch portion (24) which is between the first area (22) and the second area (23) and is formed on the substrate.

9. The module (20) according to claim 8,
wherein the first area after separation is connected consecutively with the first area of the first light emitting module in the longitudinal direction.

10. The module (20) according to claim 9,
wherein a remaining area (22A) of the first area after separation is connected consecutively with the first light emitting module so as to be adjacent with the first area (22) of the first light emitting module (20).

11. The module (20) according to claim 10, further comprising:
a second substrate (21) that is configured by the first area (22) after the first area (22) and the second area (23) are separated by the notch portion (24) in the first substrate (21); and
a second light emitting module (20) on which light emitting components (40) are arranged and mounted in a longitudinal direction of the second substrate, in the second substrate,
wherein the first area (22) of the first light emitting module (20) is connected consecutively with the first area (22) of the second light emitting module (20) such that a remaining area (22A) of the notch portion (24) caused by the separation of the second light emitting module (20) is adjacent with the first area (22) of the first light emitting module (20).

12. The module (20) according to any one of claims 8 to 11,
wherein in the first light emitting module (20), the notch portion (24) is formed, so as to ensure a distance from an edge portion (24A) of the notch portion (24) to a mounting part (30A) of the non-light emitting component (30) to be mounted as a creeping distance (A1+A2), when the non-light emitting components (30) are mounted across and above the notch portion (24) of the first substrate (21).

13. The module (20) according to claim 12,
wherein a mounting interval between the light emitting components (40) which are adjacent with each other at the same interval within the first area (22) of the first light emitting module (20) is the creeping distance or more.

14. The module (20) according to any one of claims 8 to 13,
wherein the mounting interval between the light emitting components (40) that are adjacent with each other at the same interval within the first area (22) of the first light emitting module (20) has the same dimension (P1) as a mounting interval between the light emitting components (40) that are adjacent with each other at the same interval within the first area (22) within the light emitting module (20).

15. The module (20) according to any one of claims 8 to 14,
wherein a substrate length of the longitudinal direction of the first substrate of the first area (22) of the first light emitting module (20) has the same dimension (L1) as a substrate length of the longitudinal direction of the substrate of the first area within the light emitting module (20).
